# FASCICULE DE BREVET EUROPEEN

(11) **EP 0 666 572 B1**
(45) Date de publication et mention de la délivrance du brevet: **16.10.1996**
(21) Numéro de dépôt: 95400190.5
(22) Date de dépôt: 27.01.1995
(51) Int. Cl.: G11C 16/04, G11C 14/00

(54) **Bascule bistable non volatile programmable, à état initial prédéfini, notamment pour circuit de redondance de mémoire**
Nichtflüchtiger programmierbarer Flip-Flop mit vordefiniertem Anfangszustand für Speicherredundanzschaltung
Non volatile programmable flip-flop with predefined initial state, especially for memory redundancy circuit

(30) Priorité: 31.01.1994 FR 9401034
(43) Date de publication de la demande: 09.08.1995
(73) Titulaire: SGS-THOMSON MICROELECTRONICS S.A., F-94250 Gentilly (FR)
(72) Inventeur: Mirabel, Jean Michel, F-75116 Paris (FR)
(74) Mandataire: Schmit, Christian Norbert Marie

(56) Documents cités:
- EP-A- 0 525 680
- EP-A- 0 530 376
- US-A- 4 207 615
- US-A- 4 400 799
- IEEE JOURNAL OF SOLID-STATE CIRCUITS., vol.22, no.5, Octobre 1987, NEW YORK US pages 684 - 692 CIAOCA ET AL 'A million-cycle CMOS 256K EEPROM'

## Description

L'invention concerne les circuits intégrés. Elle a pour objet une bascule bistable non volatile, programmable électriquement. Elle est destinée essentiellement, bien que non exclusivement, à être utilisée dans un circuit de redondance de mémoire en circuit intégré.

Pour bien faire comprendre l'invention dans le contexte où elle a été imaginée, on va d'abord rappeler sommairement les principes des circuits de redondance utilisés actuellement dans les mémoires de grande capacité.

Les circuits de redondance d'une mémoire sont mis en oeuvre lorsque des défauts apparaissent dans les rangées (lignes de mot servant à adresser la mémoire) ou les colonnes (lignes de bit transportant les données à lire ou écrire dans la mémoire).

Par exemple, si une colonne est défectueuse, on la remplace par une colonne de redondance de la manière suivante : l'adresse de la colonne défectueuse est mise en mémoire dans une mémoire d'adresse défectueuse; cette mémoire d'adresse défectueuse est une mémoire de type adressable par son contenu (appelée ci-après mémoire CAM); chaque fois qu'une adresse est appliquée à la mémoire principale, cette adresse est également appliquée à la mémoire CAM. Si l'adresse appliquée est identique à l'adresse mémorisée, un circuit de redondance est mis en service et agit pour déconnecter la colonne défectueuse et connecter à sa place une colonne redondante, d'une manière invisible pour l'utilisateur.

En pratique, selon l'organisation de la mémoire principale, si une colonne est défectueuse, on remplacera plutôt un groupe de colonnes contenant cette colonne défectueuse par un groupe de colonnes de redondance : en général, si un groupe de colonnes est défini par un bit d'adresse de la mémoire de grande capacité, c'est ce groupe de colonnes qu'on remplacera dans son ensemble. Dans la suite, pour simplifier, on se contentera de parler du remplacement d'une colonne plutôt que du remplacement d'un groupe de colonnes.

Pour une mémoire principale de plusieurs mégabits, on prévoit la possibilité de réparer plusieurs défauts; il y a donc autant de colonnes de redondance que de colonne ou de lignes en défaut qu'on veut pouvoir réparer. A chaque colonne de redondance est associée une mémoire CAM respective qui contient l'adresse d'une colonne défectueuse. Si on veut réparer N défauts, il faut N colonnes de redondance et N mémoires CAM. Typiquement N=36 pour une mémoire de 4 ou 16 mégabits.

Si une colonne de la mémoire principale est désignée par une adresse de M bits (par exemple M=5), chaque mémoire CAM contient au moins M+1 bit : M bits pour définir l'adresse d'une colonne défectueuse et un bit de validation pour indiquer que le circuit de redondance correspondant à cette mémoire CAM doit effectivement être activé lorsque l'adresse défectueuse est appliquée à la mémoire CAM.

Pour réaliser les mémoires CAM, on a d'abord utilisé des groupes de fusibles physiques, grillés électriquement ou grillés par un faisceau laser, chaque fusible représentant un bit d'adresse ou un bit de validation. Ces fusibles présentaient des inconvénients (fiabilité, encombrement, consommation, difficulté de programmation) et ont été rapidement remplacés par des cellules de mémoire non volatile non effaçables. Ces dernières présentaient également des inconvénients (consommation de courant importante), et on s'est orienté progressivement vers l'utilisation de bascules bistables programmables comprenant deux transistors à grille flottante pour chaque bit d'adresse ou de validation.

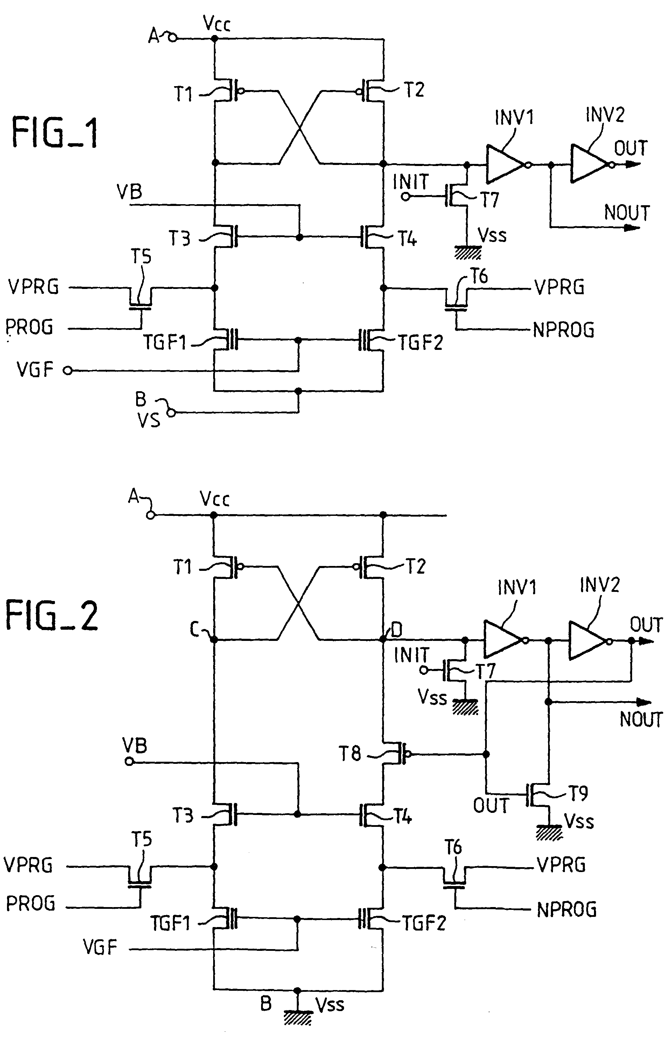

La figure 1 représente une bascule bistable programmable non volatile de la technique antérieure, constituant une cellule de mémorisation d'un bit d'adresse défectueuse (ou d'un bit de validation), et constituant donc une des M+1 cellules d'une mémoire CAM d'adresse défectueuse. Le document EP-A-0 525 680 décrit une bascule de ce type.

La sortie OUT de cette cellule est à un niveau logique 0 ou à 1 selon l'état dans lequel la bascule est programmée. Cette sortie définit donc la valeur d'un bit d'adresse (ou la valeur du bit de validation).

Si la cellule correspond à un des M bits d'adresse défectueuse, la sortie de chaque cellule de ces M Bits d'adresse est appliquée à une entrée de porte OU-Exclusif (non représentée). La porte OU-Exclusif reçoit sur une autre entrée un bit d'adresse correspondant, reçu par la mémoire principale; les sorties des portes OU-Exclusif correspondant aux différents bits d'adresse d'une même mémoire d'adresse défectueuse sont appliquées à une entrée d'une porte NOR (non représentée); la sortie de cette dernière fournit un niveau logique 1 uniquement s'il y a coïncidence entre tous les bits d'adresse àppliqués et tous les bits correspondants de la mémoire d'adresse défectueuse. La sortie de la porte NOR est validée par la sortie de la cellule de mémoire correspondant au bit de validation, par exemple grâce à une porte ET (non représentée). La sortie de la porte ET est la sortie de la mémoire CAM et sert à mettre en service un chemin de redondance chaque fois que l'adresse appliquée à la mémoire principale correspond à l'adresse défectueuse enregistrée.

Dans le cas général, il y a N mémoires d'adresse défectueuse, par exemple N=36. Lors du test de la mémoire principale, la détection d'une colonne défectueuse déclenche le stockage de l'adresse de cette colonne dans une des mémoires CAM. Les différentes mémoires CAM sont ainsi successivement programmées au fur et à mesure de la détection des défauts. En fonctionnement normal de la mémoire principale, les adresses de celle-ci sont appliquées simultanément à toutes les mémoires CAM. S'il y a correspondance de l'adresse appliquée et de l'adresse stockée dans l'une d'elles, le chemin de redondance correspondant à celle-ci est activé.

Pour permettre la programmation d'une adresse défectueuse dans une mémoire CAM, on prévoit donc qu'un bit d'adresse respectif de la mémoire principale est appliqué à chaque cellule de la mémoire CAM. La programmation est effectuée sur ordre de l'appareil de test en cas de détection d'un défaut à l'adresse en cours de test.

La cellule de mémoire individuelle représentée à la figure 1 comporte deux branches avec un transistor à grille flottante TGF1, TGF2 dans chaque branche; les branches sont agencées de manière à former une bascule bistable dès qu'un de ces deux transistors est programmé; l'état de la bascule, représenté par la sortie OUT et correspondant à un bit d'adresse ou un bit de validation, est alors fonction de celui des deux transistors qui est programmé. Au départ les deux transistors sont dans un état non-programmé, ou état vierge. Lors du test de la mémoire, on programme l'un des deux transistors pour obtenir soit un 0 soit un 1 en sortie OUT de la cellule, définissant ainsi un état stable définitif 0 ou 1 de la cellule.

Plus précisément, la cellule de la figure 1 comprend deux branches identiques en parallèle entre une borne d'alimentation A (potentiel Vcc de l'ordre de 3 volts) et une borne B; la borne B est à un potentiel VS nul en mode de lecture ou de programmation et peut aussi être portée à un potentiel VS élevé (12 volts) en mode d'effacement si un mode d'effacement est prévu (flash EPROM); en série dans chaque branche, on trouve un transistor à canal P (T1, T2), un transistor à canal N (T3, T4), et un transistor à grille flottante (TGF1, TGF2). La grille du transistor à canal P (T1, T2) de l'une des branches est reliée au drain du transistor à canal P (T2, T1) de l'autre branche. Les grilles des transistors à canal N (T3, T4) sont reliées ensemble à un potentiel commun VB dont la valeur dépend du mode de fonctionnement (environ 1,8 volt en lecture; zéro volt en programmation ou effacement pour avoir 1 volt sur le drain des cellules en lecture). Les transistors T3 et T4 sont des transistors d'isolation pour empêcher la transmission aux transistors T1 et T2 des tensions relativement élevées appliquées aux transistors à grille flottante en mode de programmation ou effacement. Les grilles des transistors à grille flottante TGF1, TGF2, sont reliées à un potentiel commun VGF dépendant du fonctionnement (3 volts environ en lecture, 12 volts environ en programmation). La source de ces transistors est reliée au noeud B (potentiel VS). Les potentiels de drain des transistors à grille flottante sont contrôlés par des transistors T5 et T6 respectivement, permettant soit de relier le drain à un potentiel de programmation VPRG (transistor T5 ou T6 conducteur) soit de laisser le drain en haute impédance (transistor T5 ou T6 bloqué). En mode de programmation, la grille du transistor T5 est contrôlée par un signal de programmation PROG et la grille de T6 par un signal complémentaire NPROG. De la sorte on choisit selon l'état du signal PROG celui des deux transistors à grille flottante qui doit être programmé et celui qui doit rester vierge. En mode de lecture, le drain des transistors T5 et T6 reste en haute impédance, la tension VPRG n'étant pas appliquée à ces drains.

La cellule est appelée "bistable" car elle possède un état stable parmi deux possibles, l'état stable qu'elle prend dépendant de celui des deux transistors qui a été programmé. L'état de la cellule est lu sur le drain d'un des transistors à canal P (T2 par exemple). Ce drain est relié à l'entrée d'un premier inverseur INV1 suivi d'un deuxième inverseur INV2. La sortie de INV2 est la sortie OUT de la cellule. La sortie de INV1 sert de sortie complémentaire NOUT si on en a besoin.

Enfin, un transistor supplémentaire T7 peut permettre, uniquement en mode de test, pour éviter les noeuds flottants quand T3 et T4 sont bloqués, de mettre à la masse temporairement (pour une initialisation de l'état de la cellule à chaque remise sous tension) l'entrée de l'inverseur INV1; la grille de ce transistor est commandée par un créneau d'initialisation INIT produit par un circuit classique de remise sous tension ("Power On Reset") non représenté.

La présente invention a pour but d'améliorer les cellules bistables de l'art antérieur, pour les rendre plus faciles à utiliser notamment dans les applications du genre qui a été décrit ci-dessus (redondance de mémoire).

On propose donc ici de modifier les cellules programmables à deux transistors à grille flottante, du type qui constituent une bascule bistable après programmation, c'est-à-dire qui ont alors deux états stables possibles, l'état pris par la cellule dépendant de la programmation effectuée; selon l'invention la cellule comporte des moyens pour déséquilibrer l'état de la cellule non programmée pour fournir un état de sortie imposé de manière certaine même avant programmation, et pour empêcher une consommation de courant de la cellule en mode de lecture même si la cellule n'est pas programmée.

Dans une réalisation pratique, la cellule peut comporter deux branches; les branches sont de préférence croisées pour réaliser une fonction bistable; chaque branche comporte un transistor à grille flottante; l'une des deux branches comporte en outre un transistor dont la conduction est contrôlée par la sortie de la cellule et qui empêche la circulation de courant dans cette branche avant programmation tout en forçant la bascule dans un état déterminé dans lequel il n'y a pas de consommation de courant dans l'autre branche.

Chaque branche peut comporter un transistor à canal P en série avec le transistor à grille flottante de cette branche, avec éventuellement en outre un transistor d'isolation en série entre le transistor à canal P et le transistor à grille flottante. Le drain du transistor à canal P de l'une des branches est de préférence relié à la grille du transistor à canal P de l'autre branche.

De préférence, un transistor de rebouclage, ayant sa grille commandée par la sortie de la cellule, est connecté en contre réaction de manière à maintenir cette sortie dans l'état pris naturellement par la bascule avant programmation.

L'invention est particulièrement avantageuse car elle permet de ne programmer que les cellules qui doivent avoir un état autre que l'état imposé avant programmation. Dans une cellule telle que celle de la figure 1, on ne peut pas laisser la cellule dans un état non programmé car il en résulterait à la fois une incertitude sur l'état de la cellule et une consommation de courant.

En effet, avec la cellule de la figure 1, l'état avant programmation est incertain : la bascule est globalement équilibrée et peut basculer d'une manière aléatoire d'un côté ou un autre; le sens du basculement dépend par exemple des petites différences de tension de seuil des deux transistors à grille flottante. De plus cette cellule consomme du courant à la lecture car les deux transistors à grille flottante sont vierges, donc conducteurs en mode de lecture. Il en résulte qu'on doit programmer la cellule dans un sens ou dans un autre : pour mémoriser un bit 0 il faut une programmation d'un des transistors, alors que pour mémoriser un bit 1 il faut programmer l'autre transistor de la cellule. Mais, dans l'application à une mémoire ayant N possibilités de redondance avec des adresses codées sur M bits, il faut alors effectuer Nx(M+1) opérations de programmation quels que soient les défauts à corriger; même une mémoire entièrement bonne doit subir ces Nx(M+1) opérations de programmation, ce qui consomme du temps inutilement.

Avec l'invention, on ne programmera que les bits de validation devant être mis à un état logique déterminé (par exemple 0) mais pas les bits de validation pouvant rester dans l'état initial (1); de même on ne programmera que les bits d'adresse défectueuses à 0 mais pas les bits d'adresse à 1.

De plus, on n'aura pas de consommation de courant, les deux branches de la cellule étant bloquées (non conductrices) dans l'état stable pris par la cellule même si elle n'a pas été programmée.

D'autres caractéristiques et avantages de l'invention apparaîtront à la lecture de la description détaillée qui suit et qui est faite en référence aux dessins annexés dans lesquels :
- la figure 1, déjà décrite représente une cellule de mémorisation connue;
- la figure 2 représente un mode de réalisation d'une cellule selon l'invention;

Une cellule de mémorisation non volatile selon l'invention est représentée à la figure 2. Elle est constituée pour l'essentiel comme celle de la figure 1, avec deux transistors supplémentaires contrôlés par la sortie OUT de la cellule. La description faite à propos de la figure 1 reste valable pour la figure 2 avec les modifications suivantes.

Un transistor T8, de préférence à canal P, est inséré entre le drain du transistor T2 (noeud D sur la figure 2) et le drain du transistor T4, drains qui auparavant étaient réunis. La grille de ce transistor T8 est reliée à la sortie OUT de la cellule, de sorte que le transistor T8 est conducteur si OUT est au niveau logique 0 et T8 est bloqué si OUT est au niveau 1.

Par ailleurs, on prévoit de préférence aussi un transistor T9 supplémentaire, de préférence à canal N, connecté en parallèle entre l'entrée de l'inverseur INV2 et la masse; il permet de mettre à zéro cette entrée. Ce transistor est commandé par la sortie OUT, de sorte que le passage de OUT à 1 entraîne la mise à zéro de l'entrée de INV2, confirmant ainsi la sortie OUT à 1 (et la sortie NOUT à 0). Le transistor T9 sert donc à maintenir la sortie OUT à 1 si elle tend à y passer comme c'est effectivement le cas à la mise sous tension de la bascule.

La cellule peut avoir deux états possibles : état non-programmé ou état programmé. On indiquera plus loin comment on effectue la programmation.

### a.) Cellule non programmée.

A cause de la présence du transistor T8 en série avec le transistor T2, le potentiel du noeud D tend à monter plus haut que le potentiel du noeud C lors de la mise sous tension, c'est-à-dire lors de l'application d'un potentiel Vcc au noeud A, le noeud B étant à la masse. On peut d'ailleurs déséquilibrer les dimensions du transistor T1 par rapport aux transistors T2 et T4 pour renforcer ce phénomène.

La conduction du transistor T1 tend alors à diminuer et celle du transistor T2 à augmenter, renforçant encore ce déséquilibre de potentiel entre les noeuds C et D. La bascule tend naturellement à mettre la sortie OUT à 1, ce qui tend à bloquer le transistor T8, remontant encore le potentiel du noeud ou en tous cas l'empêchant de descendre. Si la sortie OUT passe à 1, le transistor T9 devient conducteur, mettant l'entrée de l'inverseur INV2 à 0 et confirmant donc par rebouclage la sortie OUT à 1.

On voit donc qu'à la mise sous tension la sortie OUT passe nécessairement à 1. L'état de la bascule est imposé à 1 même sans programmation de l'un ou l'autre des transistors à grille flottante.

### b.) cellule programmée

La programmation de la cellule consiste à programmer le transistor TGF1, c'est-à-dire le transistor à grille flottante de la branche qui ne comporte pas le transistor supplémentaire T8. Cette programmation rend le transistor TGF1 non conducteur pour la tension de grille qui lui est appliquée (environ 3 volts en mode de lecture). Les autres transistors des deux branches sont initialement tous conducteurs. La bascule est donc déséquilibrée et la mise sous tension fait monter le potentiel du noeud C plus haut que le potentiel du noeud D. La bascule se met naturellement dans l'état stable OUT = 0.

Par conséquent, la bascule possède un premier état stable (OUT=1) avant programmation et un deuxième état stable après programmation (OUT=0). Il n'est pas nécessaire de programmer le transistor TGF2 pour avoir l'état stable OUT=1. Cependant, si on programme le transistor TGF2, on obtient aussi un état stable de la bascule, qui est le même état (OUT=1) que pour une cellule non programmée.

De plus, dans les deux états stables il n'y a pas de consommation de courant permanente : dans l'état OUT=0 c'est comme dans le cas de la cellule de la figure 1 : le transistor TGF1 est bloqué et empêche le passage de courant dans la première branche; le transistor T2 est bloqué et empêche le passage de courant dans la deuxième branche. Dans l'état OUT=1, le transistor T1 est bloqué et empêche le passage de courant dans la première branche; le transistor T8 est bloqué et empêche le passage de courant dans la deuxième branche.

Lorsque l'alimentation en courant du circuit intégré est coupée, il peut y avoir des incertitudes de fonctionnement de l'ensemble des éléments du circuit et il est généralement prévu un circuit de remise sous tension (appelé généralement circuit de "Power On Reset"). Pour ce qui concerne la cellule de mémoire de la figure 2, on prévoit que ce circuit (non représenté) fournit un créneau d'initialisation INIT à la grille du transistor T7 au moment de la remise sous tension. Ce créneau met temporairement à zéro le potentiel du noeud D et fait donc passer la sortie OUT à 0. Puis le créneau est relâché et la bascule prend l'état que lui impose son état de programmation : OUT=1 si la cellule n'est pas programmée ou si TGF2 est programmé, OUT=0 si TGF1 est programmé.

Pour effectuer la programmation du transistor TGF1, on applique une tension VPRG d'environ 6 volts sur le drain du transistor T5, la grille de ce transistor recevant un signal de mise en conduction PROG alors que la grille du transistor T6 reçoit un signal complémentaire NPROG qui le laisse bloqué. Pour programmer le transistor TGF2 (si on le souhaite), c'est la grille du transistor T6 qui reçoit un signal de mise en conduction pour transmettre la tension VPRG, la grille du transistor T5 recevant un signal complémentaire. Les cellules ou groupes de cellules qui ne doivent pas être programmées ni dans un sens ni dans l'autre ne reçoivent pas la tension VPRG sur les drains des transistors T5 et T6. Ces drains restent en haute impédance.

Dans une mémoire d'adresse défectueuse, on n'effectuera pas la programmation des cellules s'il n'y a pas d'adresse défectueuse à enregistrer, mais si une adresse défectueuse doit être stockée on pourra programmer les cellules comme celles de la figure 1 en utilisant à la fois le transistor TGF1 pour les bits d'adresse 0 et le transistor TGF2 pour les bits d'adresse 1. C'est pourquoi un signal PROG représentant un bit d'adresse ou de validation est appliqué au transistor T5 et un signal complémentaire NPROG est appliqué au transistor T6.

Mais si le nombre de défauts à corriger dans la mémoire principale est inférieur au nombre de mémoires d'adresses défectueuses disponibles, on ne sera pas obligé de programmer les cellules des mémoires d'adresse inutilisées. En particulier, dans le cas d'une mémoire ne comportant aucun défaut, on pourra laisser toutes les cellules de mémoires CAM dans l'état non programmé.

L'invention est applicable y compris avec des variantes, et notamment celles qui sont décrites dans des demandes de brevet déposées simultanément par la Demanderesse. En particulier, on peut prévoir que la programmation s'effectue en appliquant une tension de 5 à 7 volts sur la source (et non pas zéro volt), et une tension nulle sur le drain du transistor à grille flottante qui doit être programmé (et non ps 5 à 7 volts), le drain de l'autre transistor restant en haute impédance. Egalement, on peut prévoir que des transistors d'isolation sont insérés entre le transistor T5, T6 respectivement et le drain du transistor à grille flottante correspondant. Ces transistors sont commandés par un signal CAMSEL commun, qui ne rend conducteur ces transistors que lorsque la cellule doit être programmée (en même temps que d'autres cellules correspondant à une même adresse défectueuse à stocker); lorsque d'autres groupes de cellules sont à programmer ou lorsqu'on est en mode de lecture, les transistors d'isolation sont bloqués.

## Revendications

1. Cellule de mémoire programmable à deux transistors à grille flottante (TGF1, TGF2), du type qui constitue une bascule bistable dont l'état est défini par programmation d'un des deux transistors, caractérisée en ce qu'elle comporte des moyens (T8) pour déséquilibrer l'état de la bascule non programmée pour fournir un état de sortie imposé de manière certaine même avant programmation, et pour empêcher une consommation de courant de la cellule en mode de lecture même si la cellule n'est pas programmée.

2. Cellule de mémoire selon la revendication 1, caractérisée en ce que la cellule comporte deux branches croisées pour réaliser une fonction bistable, chaque branche comportant un transistor à grille flottante, l'une des deux branches comportant en outre un transistor (T8) dont la conduction est contrôlée par la sortie (OUT) de la cellule et qui empêche la circulation de courant dans cette branche avant programmation tout en forçant la bascule dans un état déterminé dans lequel il n'y a pas de consommation de courant dans l'autre branche.

3. Cellule de mémoire selon la revendication 2, caractérisée en ce que chaque branche comporte un transistor à canal P (T1, T2) en série avec le transistor à grille flottante (TGF1, TGF2) de cette branche, un transistor d'isolation (T3, T4) en série entre le transistor à canal P et le transistor à grille flottante, le drain du transistor à canal P de l'une des branches étant relié à la grille du transistor à canal P de l'autre branche.

4. Cellule de mémoire selon l'une des revendications précédentes, caractérisée en ce qu'un transistor de rebouclage (T9), ayant sa grille commandée par la sortie de la cellule, est connecté en contre réaction de manière à maintenir cette sortie dans l'état pris naturellement par la bascule avant programmation.

5. Mémoire en circuit intégré, comportant une mémoire principale et des circuits de redondance pour corriger des défauts de la mémoire principale, caractérisée en ce qu'elle comporte des cellules de mémoire selon l'une des revendications précédentes pour stocker les adresses d'éléments défectueux de la mémoire principale.

## Patentansprüche

1. Programmierbare Speicherzelle mit zwei Transistoren mit offenem Gitter (TGF1, TGF2) derart, daß sich eine bistabile Kippstufe ergibt, deren Zustand definiert ist durch Programmierung eines der zwei Transistoren, dadurch gekennzeichnet, daß sie Vorrichtungen (T8) umfaßt, um den Zustand der nichtprogrammierten Kippschaltung aus dem Gleichgewicht zu bringen, um für einen Ausgangszustand zu sorgen, der selbst vor Programmierung sicher eingehalten wird, und um einen Stromverbrauch der Zelle beim Lesen zu verhindern, selbst wenn die Zelle nicht programmiert ist.

2. Speicherzelle nach Anspruch 1, dadurch gekennzeichnet, daß die Zelle zwei sich kreuzende Zweige umfaßt, um zu einer bistabilen Funktion zu gelangen, wobei jeder Zweig einen Transistor mit offenem Gitter umfaßt, wobei einer der beiden Zweige außerdem einen Transistor (T8) umfaßt, dessen Leitzustand über den Ausgang (OUT) der Zelle gesteuert wird und der den Stromfluß in diesem Zweig vor Programmierung unterbindet, indem die Kippschaltung in einen festgelegten Zustand gezwungen wird, in welchem kein Strom in dem anderen Zweig verbraucht wird.

3. Speicherzelle nach Anspruch 2, dadurch gekennzeichnet, daß jeder Zweig einen P-Kanaltransistor (T1, T2) in Serie mit dem Transistor mit offenem Gitter (TGF1, TGF2) dieses Zweiges, einen Isolationstransistor (T3, T4) in Serie zwischen dem P-Kanaltransistor und dem Transistor mit offenem Gitter umfaßt, wobei der Drain des P-Kanaltransistors des einen Zweiges mit dem Gitter des P-Kanaltransistors des anderen Zweiges verbunden ist.

4. Speicherzelle nach einem der vorangehenden Ansprüche, dadurch gekennzeichnet, daß ein Transistor zum Wiedereinschleifen (T9), dessen Gitter durch den Ausgang der Zelle angesteuert wird, in Gegenwirkung verbunden ist, so daß dieser Ausgang im Zustand verbleibt, der natürlicherweise durch die Kippschaltung vor der Programmierung eingenommen wird.

5. Speicher in integrierter Schaltung, umfassend einen Hauptspeicher und Redundanzschaltkreise zum Korrigieren bei Ausfall des Hauptspeichers, dadurch gekennzeichnet, daß er Speicherzellen gemäß einem der vorangehenden Ansprüche umfaßt, um die Adressen der defekten Elemente des Hauptspeichers zu speichern.

## Claims

1. Programmable memory cell with two floating gate transistors (TGF1, TGF2), of the type which forms a bistable flip-flop whose state is defined by the programming of one of the two transistors, characterised in that it includes means (T8) for unbalancing the state of the unprogrammed flip-flop to supply an output state imposed in a certain manner even before programming, and to prevent consumption of current by the cell in read mode even if the cell is not programmed.

2. Memory cell according to Claim 1, characterised in that the cell has two crossover legs to produce a bistable function, each leg having a floating gate transistor, one of the two legs also having a transistor (T8) whose conduction is controlled by the output (OUT) of the cell and which prevents the circulation of current in this leg before programming whilst forcing the flip-flop into a given state in which there is no consumption of current in the other leg.

3. Memory cell according to Claim 2, characterised in that each leg has a p-channel transistor (T1, T2) in series with the floating gate transistor (TGF1, TGF2) of this leg, an isolation transistor (T3, T4) in series between the p-channel transistor and the floating gate transistor, the drain of the p-channel transistor of one of the legs being connected to the gate of the p-channel transistor of the other leg.

4. Memory cell according to one of the preceding claims, characterised in that a loop-back transistor (T9), having its gate controlled by the output of the cell, is connected as negative feedback so as to keep this output in the state naturally taken up by the flip-flop before programming.

5. Integrated-circuit memory, having a main memory and redundancy circuits for correcting defects in the main memory, characterised in that it includes memory cells according to one of the preceding claims for storing the addresses of defective elements of the main memory.
